Europäisches Patentamt

European Patent Office

Office européen des brevets

(11) Veröffentlichungsnummer: **0 503 340 A1**

# EUROPÄISCHE PATENTANMELDUNG

(21) Anmeldenummer: **92103016.9**

(51) Int. Cl.⁵: **H03K 17/95**

(22) Anmeldetag: **22.02.92**

(30) Priorität: **08.03.91 DE 4107457**

(43) Veröffentlichungstag der Anmeldung:
**16.09.92 Patentblatt 92/38**

(84) Benannte Vertragsstaaten:
**DK FR GB IT SE**

(71) Anmelder: **Werner Turck GmbH & Co. KG
Goethestrasse 7
W-5884 Halver(DE)**

(72) Erfinder: **Nest, Andreas, Dr.
Händelstrasse 50
W-4690 Herne 1(DE)**
Erfinder: **Müller, Jens
Industriestrasse 10
W-5608 Radevormwald(DE)**

(74) Vertreter: **Peerbooms, Rudolf, Dipl.-Phys.
Postfach 200 208 Dickmannstrasse 45c
W-5600 Wuppertal 2(DE)**

(54) **Induktiver, magnetfeldabhängiger Näherungsschalter.**

(57) Ein induktiver Näherungsschalter weist eine in einem HF-Schwingkreis (5) eines Oszillators (1) liegende Sensorspule (6) auf, in deren HF-Magnetfeld ein magnetisierbarer Körper (9) aus amorphen Metall angeordnet ist, der durch das Magnetfeld eines sich nähernden Auslösers in magnetische Sättigung treibbar ist. Damit das Schaltverhalten temperaturunabhängig bei gleichzeitiger Reduzierung der Anzahl elektronischer Bauteile wird, ist vorgesehen, daß ein Amorphmetall-Körper (9) verwendet wird, der eine bevorzugte Magnetisierungsrichtung und in dieser Vorzugsrichtung eine nahezu rechteckförmige Hysteresekurve (magnetische Induktion gegen magnetische Feldstärke) aufweist, und daß der Schaltpunkt des Näherungsschalters je nach Richtung des Auslösemagnetfeldes an eine der beiden Sprungstellen der Hysteresekurve gelegt ist.

Fig.1

Die Erfindung betrifft einen induktiven Näherungsschalter, welcher durch ein Auslöse-Magnetfeld eines sich annähernden Auslösers betätigt wird, mit einer in einem HF-Schwingkreis eines Oszilltators liegenden Sensorspule, in deren HF-Magnetfeld ein magnetisierbarer Körper aus amorphem oder zumindest überwiegend amorphem Metall angeordnet ist, der durch das Auslösemagnetfeld im Schaltpunkt des Näherungsschalters unter Entdämpfung des HF-Schwingkreises in magnetische Sättigung treibbar ist.

Aus dem DE-GM 85 17 733 ist ein magnetfeldabhängiger, induktiver Näherungsschalter bekannt, der bei Annäherung eines Auslöse-Magnetfeldes schaltet. Beim dortigen Näherungsschalter hängt die Schwingungsamplitude von dem Grad der Kernsättigung eines ferritischen Spulenkerns mit zugeordnetem, weichmagnetischem Jochkörper ab, deren Hysteresekurve (magnetische Induktion B gegen magnetische Feldstärke H) S-förmig verläuft. Wird ein Arbeitspunkt auf der Hysteresekurve im Bereich geringer Auslöse-Magnetfeldstärke gewählt, bewirkt eine fortschreitende Sättigung bei Annäherung eines Auslöse-Magnetfeldes einen Anstieg des Oszillatorstromes. Bei einem Schaltpunkt im Bereich großer Auslöse-Magnetfeldstärke erfolgt ein Absinken des Oszillatorstromes. Eine entsprechende Überwachung des Oszillatorstromes löst den Schaltvorgang aus. Ein wesentlicher Nachteil dieses Näherungsschalters ist sein temperaturabhängiges Driften der Schaltpunkte auf der Hysteresekurve und die damit verbundene Änderung des Schaltabstandes. Ferner ist der zweiteilige Aufbau aus einem ferritischen Spulenkörper und einem weichmagnetischen Jochkörper aufwendig.

Aus der DE-OS 35 44 809 ist ein Näherungsschalter bekannt, bei welchem durch das Auslösemagnetfeld ein Amorphmetall-Körper, bekannt unter dem geschützten Warenzeichen "Vitrovac", in Sättigung getrieben wird. Der dortige, im Grundzustand stark bedämpfte Schwingkreis wird dabei entdämpft und zu starken Schwingungen angeregt. In Verbindung mit der speziellen Ausbildung des Oszillators mit Schwingkreis- und Koppelspule sind dort große Ansprechabstände bei kleiner Baugröße erreichbar. Ferner zeichnet sich die Verwendung von Amorphmetall-Körpern anstelle von z. B. ferritischen Spulenkörpern durch eine große Alterungsbeständigkeit und ein weitgehend temperaturunempfindliches Sättigungsverhalten aus. Davon unberührt bleibt aber das unterschiedliche Temperaturverhalten der übrigen Komponenten des Näherungsschalters, z. B. der Vergußmasse und des Spulendrahtes. Eine Verschiebung des Schaltpunktes auf der Hysteresekurve und ein damit veränderter Ansprechabstand des Näherungsschalters bei größeren Temperaturunterschieden ist nur durch qualitativ hochwertige Bauteile und eine zusätzliche Temperaturstabilisierung der Elektronik zu verhindern. Darüber hinaus ist noch meist eine künstliche Alterung des fertigen Näherungsschalters vorzusehen. Ferner muß dort bei jedem Näherungsschalter der Verstärkungsfaktor des Oszillatorverstärkers individuell eingestellt werden. In der Produktion bedeutet dies einen erheblichen zusätzlichen Arbeitsaufwand.

Der Erfindung liegt die Aufgabe zugrunde, das Schaltverhalten eines gattungsgemäßen Näherungsschalters unter Reduzierung der Anzahl von elektronischen Bauteilen temperaturunabhängig zu machen und die Fertigung zu vereinfachen.

Erfindungsgemäß wird die Aufgabe dadurch gelöst, daß ein Amorphmetall-Körper verwendet wird, der eine bevorzugte Magnetisierungsrichtung und in dieser Vorzugsrichtung dadurch eine nahezu rechteckförmige Hysteresekurve B gegen H, magnetische Induktion gegen magnetische Feldstärke, aufweist, und daß der Schaltpunkt des Näherungsschalters je nach Abfahrrichtung der Hysteresekurve an eine der beiden Sprungstellen der Hysteresekurve gelegt ist.

Bei entsprechender Ausrichtung eines so vorbehandelten Amorphmetall-Körpers bezüglich des zu erfassenden Auslöse-Magnetfeldes wird ab einer bestimmten magnetischen Feldstärke das Amorphmetall-Material sprunghaft in Sättigung getrieben. Der zur Sättigung notwendige Feldstärkenanstieg liegt dabei im Bereich des Auflösevermögens bekannter Meßgeräte, so daß sich die Hysteresekurve - magnetische Induktion B gegen magnetische Feldstärke H - als rechteckförmig darstellt. Für den erfindungsgemäßen Näherungsschalter existieren daher, unabhängig von Temperatureinflüssen, nur zwei Zustände des Schwingkreises, nämlich bedämpft durch den ungesättigten Amorphmetall-Körper und entdämpft durch den durch das Auslöse-Magnetfeld in Sättigung getriebenen Amorphmetall-Körper. Die Auswertung dieser weit auseinanderliegenden Oszillatorzustände durch die Elektronik kann daher ohne jede weitere Berücksichtigung der Temperaturdrift erfolgen, wenn der Schaltpunkt an eine der beiden Sprungstellen der Hysteresekurve gelegt ist. Neben der Einsparung von Bauteilen, z. B. temperaturabhängigen Widerständen, erweist es sich als Vorteil, daß das unterschiedliche Temperaturverhalten einzelner Bauteile keinen Einfluß mehr auf die Lage des Schaltpunktes des Näherungsschalters hat. Insbesondere ist der bisher kritische Verguß der HF-Komponenten des Oszillators nunmehr problemlos auch mit sehr preiswerten Vergußmassen möglich.

Neben der Einsparung von elektronischen Bauteilen erweist sich der erfindungsgemäße Näherungsschalter auch durch eine Reduzierung der erforderlichen Fertigungsschritte als vorteilhaft. Da das Schaltverhalten temperaturunabhängig ist und nur von der Sättigung des Amorphmetall-Körpers abhängt, kann auf eine künstliche Alterung der übrigen Bauteile des Näherungsschalters verzichtet werden. Insbesondere ist auch eine individuelle Einstellung des Oszillatorverstärkers nicht mehr erforderlich, da es für den Oszillator infolge der sprunghaften Änderung der Sättigung nur den be- oder entdämpften Zustand gibt.

Für die Erfindung wird vorzugsweise ein bei einer Temperatur zwischen 300° C und 350° C innerhalb eines Magnetfeldes getemperter Amorphmetall-Körper verwendet. Diese Temperung stellt sicher, daß die magnetischen Eigenschaften des künstlich gealterten Amorphmetall-Körpers sich über den technisch interessierenden Temperaturbereich hinweg nicht ändern.

Der Amorphmetall-Körper kann der Erfindung zufolge aus Folienmaterial bestehen, das eine Stärke zwischen 20 Mikron und 50 Mikron aufweist. Folienartiges Amorphmetall wird von der Firma Vaccumschmelze GmbH, Hanau, unter dem geschützten Warenzeichen "Vitrovac" mit der Zusatzcodierung "Z", z. B. "6150Z", vertrieben, welches bereits in der beschriebenen Weise getempert ist. Dieses Folienmaterial, das eine Stärke zwischen 20 Mikron und 25 Mikron aufweist, läßt sich hervorragend weiterverarbeiten, ist sehr elastisch und widerstandsfähig gegenüber mechanischen Belastungen. In umfangreichen Erprobungen zeigte sich, daß dieses Material bereits bei extrem schwachen Magnetfeldern, z. B. durch Streufelder von Motoren hervorgerufen, in Sättigung treibbar ist. Um diese überempfindlichkeit zu beseitigen, kann der Erfindung zufolge vorgesehen werden, daß der Amorphmetall-Körper aus zwei aufeinandergefalteten Folienlagen von jeweils etwa 20 Mikron bis 25 Mikron Stärke besteht. Durch diese Maßnahme wird die Querschnittsfläche des Amorphmetall-Körpers soweit vergrößert, daß zu seiner Sättigung höhere Feldstärken notwendig werden. Die Empfindlichkeit des Näherungsschalters kann durch weitere Faltlagen noch weiter gesenkt werden. Ein weiterer Vorteil des bevorzugt verwendeten Materials ist seine sehr hohe Sättigungsinduktion.

In Ausgestaltung der Erfindung kann ferner vorgesehen sein, daß der Amorphmetall-Körper als Band ausgebildet ist. Die bevorzugte Magnetisierungsrichtung zeigt dann in Bandlängsrichtung. Solches Material ist handelsüblich und kann in einfachster Weise von einer Rolle in Längen zwischen 5 mm und 50 mm bei einer Breite von 0,5 mm bis 5 mm abgelängt werden, wobei mit zunehmender Länge die Ansprechempfindlichkeit des Näherungsschalters erhöht wird.

Der Erfindung zufolge kann das Band geradlinig sein, wobei es bevorzugt den Spulentorus axial auf seiner Symmetrieachse durchsetzt. Hierdurch erhält man einen sehr empfindlichen, temperaturunabhängigen Näherungsschalter. Der erreichbare Ansprechabstand wird durch die Abmessungen, speziell die Länge, des geradlinigen Bandes bestimmt. In dieser Ausführungsform eignet sich der Näherungsschalter insbesondere zum Erfassen von sich senkrecht zu den Hauptflächen des Bandes bewegenden Auslösern.

Nach der Erfindung kann alternativ auch vorgesehen werden, daß das Band als offener oder geschlossener, die Wicklung der Sensorspule umfassender Ring ausgebildet ist. Ein solcher Näherungsschalter spricht bei geschlossenem Ring in allen Radialrichtungen, bezogen auf den Ring, mit etwa gleichem Schaltabstand an.

Die Erfindung wird im folgenden anhand der Zeichnung näher erläutert. Es zeigen:

Fig. 1    ein Prinzipschaltbild eines Näherungsschalters gemäß einer ersten Ausführungsform mit einem ringförmigen Amorphmetall-Band,

Fig. 2    eine Sensorspule, deren Torus von einem geradlinigen, einlagigen Amorphmetall-Band durchsetzt wird,

Fig. 3    eine weitere Ausführungsform der Sensorspule, deren Torus von einem doppellagigen Amorphmetall-Band durchsetzt wird, und

Fig. 4    die Hysteresekurve "magnetische Induktion B gegen magnetische Feldstärke H" des verwendeten Amorphmetall-Körpers.

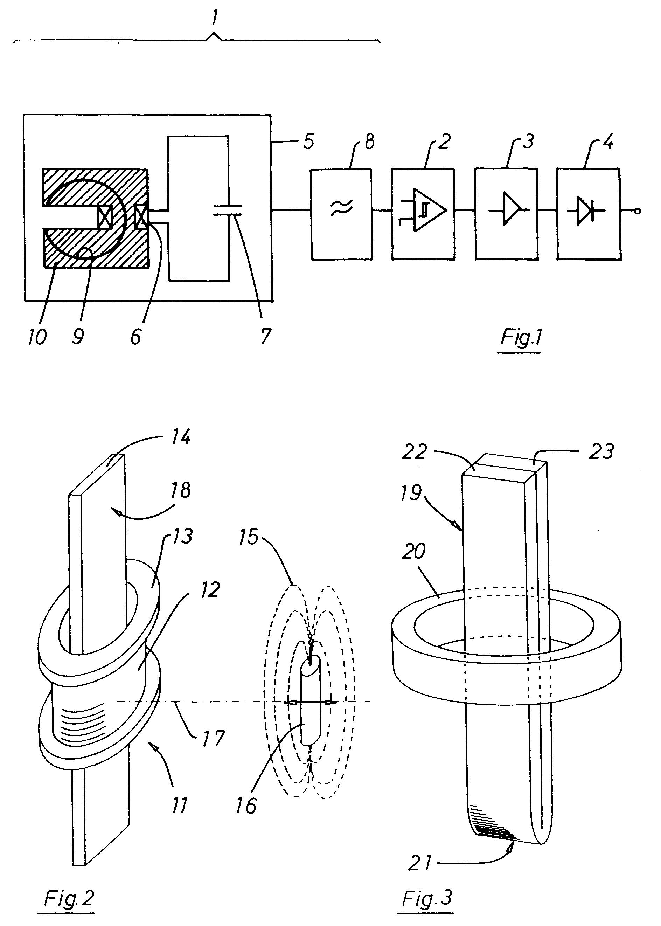

Fig. 1 zeigt einen induktiven Näherungsschalter, der aus den Baugruppen Oszillator 1, Auswertestufe 2, Schaltverstärker 3 und Schaltglied 4 besteht. Der beispielhaft gezeigte Oszillator 1 umfaßt einen Schwingkreis 5, gebildet von einer auch als Sensorspule 6 dienenden Schwingkreisspule und einem Kondensator 7, und einen Oszillatorverstärker 8. Die Wicklung der Sensorspule 6 wird von einem bandförmigen, als offener Ring ausgebildetem Amorphmetall-Körper 9 umfaßt, wobei der Ring den Spulentorus durchsetzts. Der Amorphmetall-Körper 9 und die Sensorspule 6 werden von einem gemeinsamen Spulenkörper 10 zusammengehalten.

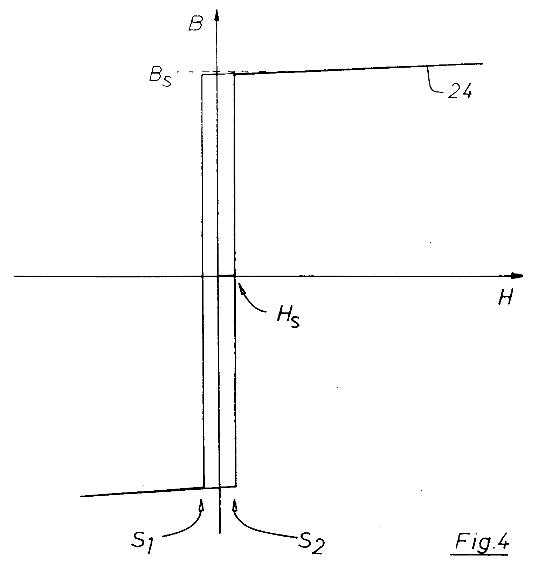

Bei Annäherung eines Auslöse-Magnetfeldes in der Darstellungsebene nach Fig. 1 steigt die Feldstärke im Bereich der Sensorspule 6 an, und bei einer bestimmten magnetischen Feldstärke $H_s$ - (vergleiche auch Fig. 4) wird der Amorphmetall-Körper 9 sprunghaft in Sättigung versetzt. Der im Grundzustand stark bedämpfte Oszillator 1 wird dabei voll entdämpft. Der Oszillatorverstärker 8 kann deshalb in der Nähe seiner Maximalverstärkung betrieben werden, wobei der individuelle Verstärkungsgrad einzelner Exemplare von Verstärkern 8 den Ansprechabstand der Näherungsschalter nicht beeinflußt, weshalb eine Einzelanpassung des Oszillatorverstärkers 8 sich erübrigt. Da ferner das magnetische Verhalten des Amorphmetall-Körpers 9 temperaturunabhängig ist, sind bei den elektronischen Baugruppen 2, 3, 4 und 8 keine zusätzlichen Maßnahmen zur Temperaturstabilisierung mehr erforderlich. Der Spulenkörper 10 kann aus einem einfachen Kunststoff bestehen und darüber hinaus läßt sich die Schaltung in preiswerter Vergußmasse einbetten.

Die Temperaturstabilität des Näherungsschalters ist von dem elektronischen Schaltungsaufbau unabhängig. So kann z. B. im gezeigten Schwingkreis 5 an die Stelle der einfachen Sensor- bzw. Schwingkreisspule 6 eine Meißner- oder eine Hartley-Schaltung treten, bei denen neben der eigentlichen Schwingkreisinduktivität eine zusätzliche Rückkopplungsspule verwendet wird.

Fig. 2 zeigt eine Sensorspule 11, deren Wicklung 12 auf einen Spulenkörper 13 aufgebracht ist. Der Amorphmetall-Körper ist als geradliniges Band 14 ausgebildet und durchsetzt den Spulentorus auf dessen Längsachse. Die bevorzugte Magnetisierungsrichtung ist entlang der Längsachse orientiert. Die Feldstärke $H_s$ eines entsprechend gepolten Auslösemagnetfeldes 15, die einem bestimmten Ansprechabstand zugeordnet ist, versetzt das Band 14 sprunghaft in Sättigung. Dies gilt insbesondere, wenn sich der Auslöser 16 auf einer Symmetrielinie 17 senkrecht zu einer Breitseite 18 des Bandes 14 bewegt, denn wegen seiner geringen Materialstärke liegt das Band 14 bei Annäherung des Auslösemagnetfeldes 15 in einem Bereich nahezu gleicher magnetischer Feldstärke. So erfolgt ein äußerst präzises Schalten, und gleichzeitig werden sehr große Ansprechabstände des Näherungsschalters ermöglicht. Die Größe des Ansprechabstandes wird dabei unter anderem von der Länge des Bandes 14 bestimmt.

Wird ein handelsübliches Amorphmetall-Band von einer Stärke von 20 Mikron bis 25 Mikron bei den Ausführungsformen nach den Fig. 1 und 2 verwendet, haben Versuche gezeigt, daß ein solches Band bereits durch sehr kleine Feldstärken in Sättigung treibbar ist, wie diese häufig bereits von elektrischen Maschinen und Anlagen erzeugt werden. Um dieser Störempfindlichkeit zu begegnen, kann die zur Sättigung des Amorphmetall-Körpers erforderliche Feldstärke heraufgesetzt werden. Dies ist durch eine Querschnittsvergrößerung erreichbar, indem man mehrere Bandstücke aufeinander legt oder ein Band faltet. In Fig. 3 durchsetzt ein zweilagiges Amorphmetall-Band 19 den Torus einer Sensorspule 20. Die Stärke des verwendeten Materials zwischen 20 Mikron und 25 Mikron sowie seine hervorragenden mechanischen Eigenschaften lassen sehr kleine Faltkrümmungen 21 zu, so daß beide Lagen 22, 23 über ihre gesamte Kontaktfläche fest aneinanderliegen.

Die magnetischen Eigenschaften der verwendeten Amorphmetall-Körper 9, 14, 19 sind durch die Hysteresekurve 24 "magnetische Induktion B gegen magnetische Feldstärke H" nach Fig. 4 veranschaulicht. Bei einem Anstieg der magnetischen Feldstärke H, z. B. bei der Annäherung eines Auslöse-Magnetfeldes, ist zunächst kein entscheidender Anstieg der magnetischen Induktion B zu erkennen. Wird die Sättigungsmagnetfeldstärke $H_s$ erreicht, springt die Induktion B auf den Wert der Sättigungsinduktion $B_s$, der zur vollständigen magnetischen Sättigung des Amorphmetall-Körpers ausreicht. Bei einem weiteren Anstieg der Feldstärke H über die Sättigungsmagnetfeldstärke $H_s$ hinaus, steigt die magnetische Induktion B nicht mehr merkbar an. Bei einer Festlegung des Schaltpunktes des Näherungsschalters auf die Sprungstellen $S_1$ oder $S_2$ der Hysteresekurve 24 existieren für den Schwingkreis 5 des Oszillators 1 nur die zwei exakt definierten Zustände "bedämpft" oder "entdämpft", womit ein eindeutiges, temperaturunabhängiges Schaltkriterium gegeben ist. Dazu trägt auch die sehr hohe Sättigungsinduktion $B_s$ bei, die gegenüber der Sättigungsinduktion bisher verwendeten Materials etwa verdoppelt ist.

Bezugszeichenliste

| | |
|---|---|
| 1 | Oszillator |
| 2 | Auswertestufe |
| 3 | Schaltverstärker |
| 4 | Schaltglied |
| 5 | Schwingkreis |
| 6 | Sensorspule |
| 7 | Kondensator |
| 8 | Oszillatorverstärker |
| 9 | Amorphmetall-Körper |
| 10 | Spulenkörper |
| 11 | Sensorspule |
| 12 | Wicklung |
| 13 | Spulenkörper |
| 14 | Amorphmetall-Band |
| 15 | Auslöse-Magnetfeld |
| 16 | Auslöser |
| 17 | Symmetrielinie |
| 18 | Breitseite |
| 19 | gefaltetes Amorphmetall-Band |
| 20 | Sensorspule |
| 21 | Faltkrümmung |
| 22 | Faltlage |
| 23 | Faltlage |
| 24 | Hysteresekurve |
| B | magnetische Induktion |
| $B_s$ | magnetische Sättigungsinduktion |
| H | magnetische Feldstärke |
| $H_s$ | Sättigungsmagnetfeldstärke |
| $S_1$ | Sprungstelle |
| $S_2$ | Sprungstelle |

**Patentansprüche**

1. Induktiver Näherungsschalter, welcher durch ein Auslöse-Magnetfeld eines sich annähernden Auslösers betätigt wird, mit einer in einem HF-Schwingkreis eines Oszillators liegenden Sensorspule, in deren HF-Magnetfeld ein magnetisierbarer Körper aus amorphem oder zumindest überwiegend amorphem Metall angeordnet ist, der durch das Auslösemagnetfeld im Schaltpunkt des Näherungsschalters unter Entdämpfung des HF-Schwingkreises in magnetische Sättigung treibbar ist, dadurch gekennzeichnet, daß ein Amorphmetall-Körper (9, 14, 19) verwendet wird, der eine bevorzugte Magnetisierungsrichtung und in dieser Vorzugsrichtung eine nahezu rechteckförmige Hysteresekurve (24) B gegen H (magnetische Induktion gegen magnetische Feldstärke) aufweist, und daß der Schaltpunkt des Näherungsschalters je nach Abfahrrichtung der Hysteresekurve (24) an eine der beiden Sprungstellen ($S_1$, $S_2$) der Hysteresekurve (24) gelegt ist.

2. Näherungsschalter nach Anspruch 1, dadurch gekennzeichnet, daß ein bei einer Temperatur zwischen 300° C und 350° C innerhalb eines Magnetfeldes getemperter Amorphmetall-Körper (9, 14, 19) verwendet ist.

3. Näherungsschalter nach Anspruch 1 und 2, dadurch gekennzeichnet, daß der Amorphmetall-Körper (9, 14, 19) aus Folienmaterial besteht.

4. Näherungsschalter nach Anspruch 3, dadurch gekennzeichnet, daß das Folienmaterial eine Stärke zwischen 20 Mikron und 50 Mikron aufweist.

5. Näherungsschalter nach Anspruch 3, dadurch gekennzeichnet, daß der Amorphmetall-Körper (19) aus zwei aufeinandergefalteten Folienlagen von jeweils etwa 20 Mikron bis 25 Mikron besteht.

6. Näherungsschalter nach den Ansprüchen 4 oder 5, dadurch gekennzeichnet, daß der Amorphmetall-Körper (9, 14, 19) als Band ausgebildet ist.

7. Näherungsschalter nach Anspruch 6, dadurch gekennzeichnet, daß das Band (14) geradlinig ist.

8. Näherungsschalter nach Anspruch 6, dadurch gekennzeichnet, daß das Band als offener Ring (9) oder als geschlossener Ring ausgebildet ist, der die Wicklung der Sensorspule (6) umfaßt.

Fig.1

Fig.2

Fig.3

Fig.4

Europäisches Patentamt

**EUROPÄISCHER RECHERCHENBERICHT**

Nummer der Anmeldung

EP 92 10 3016

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | EP-A-0 218 042 (WERNER TURCK GMBH & CO KG) <br> * gesamtes Dokument *; & DE - A - 3544809 (Kat. D) <br> --- | 1-8 | H 03 K 17/95 |
| Y | FIRMENDRUCKSCHRIFT PV-006 DER FIRMA VAC, VACUUMSCHMELZE GMBH Ausgabe 07/89, Hanau, DE; "Amorphe Metalle VITROVAC: Legierungen und Anwendungen" <br> * gesamtes Dokument * <br> --- | 1-8 | |
| A | EP-A-0 279 268 (WERNER TURCK GMBH & CO KG) <br> * Figur 1; Zusammenfassung * <br> --- | 1 | |
| P,A | DE-A-4 003 426 (WERNER TURCK GMBH & CO KG) <br> * Figur 3; Zusammenfassung * <br> --- | 1 | |
| D,A | DE-U-8 517 733 (G. SOYCK et al.) <br> --- | | |
| A | DE-A-2 546 676 (WESTERN ELECTRIC CO INC) <br> * Seite 3, Zeilen 17-24 * <br> --- | | RECHERCHIERTE SACHGEBIETE (Int. Cl.5) <br><br> G 01 V 3/10 <br> H 03 K 17/95 |
| A | DE-A-3 033 258 (MATSUSHITA ELECTRIC INDUSTRIAL CO LTD) <br> * Patentanspruch 1 * <br> --- | | |
| A | DE-A-3 001 889 (ALLIED CHEMICAL CORP) <br> --- | | |
| A | ETZ Band 109, Heft 20, 1988, Seiten 958-961; T. PFEIFER et al.: "Amorphe Metalle in induktiven Bauelementen" <br> ----- | | |

Der vorliegende Recherchenbericht wurde für alle Patentansprüche erstellt

| Recherchenort | Abschlußdatum der Recherche | Prüfer |
|---|---|---|
| BERLIN | 09-04-1992 | ARENDT M |